(19) Europäisches Patentamt

European Patent Office

Office européen des brevets

(11) **EP 1 394 123 A1**

(12) **EUROPEAN PATENT APPLICATION**

(43) Date of publication:
03.03.2004 Bulletin 2004/10

(51) Int Cl.7: **C03B 11/08**

(21) Application number: 03077597.7

(22) Date of filing: 18.08.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: 29.08.2002 US 230908

(71) Applicant: **EASTMAN KODAK COMPANY**
**Rochester, New York 14650 (US)**

(72) Inventors:
• **Winters, Mary K. Eastman Kodak Company**
**Rochester New York 14650-2201 (US)**
• **Alonzo, Carlos F. Eastman Kodak Company**
**Rochester New York 14650-2201 (US)**

• **McLaughlin, Paul O. Eastman Kodak Company**
**Rochester New York 14650-2201 (US)**
• **Pulver, John C. Eastman Kodak Company**
**Rochester New York 14650-2201 (US)**
• **Hrycin, Anna L. Eastman Kodak Company**
**Rochester New York 14650-2201 (US)**
• **Stephenson, Donald A.**
**Eastman Kodak Company**
**Rochester New York 14650-2201 (US)**

(74) Representative: **Haile, Helen Cynthia**
**Kodak Limited,**
**Patents Department (W92-3A),**
**Headstone Drive**
**Harrow, Middlesex HA1 4TY (GB)**

(54) **Mechanism to mold glass lenses using an implanted precision glass molding tool**

(57) A method for fabricating a molding tool (104) for mold glass optical elements therewith is taught. The method comprises the steps of figuring the molding tool to have a predetermined mold surface (106); applying an attenuating coating to the predetermined mold surface; implanting metal ions through the attenuating coating and into the predetermined mold surface; and removing the attenuating coating leaving the predetermined mold surface with metal ions implanted therein (108). The method of fabrication allows for the molding tool made therewith to be used for molding optical elements from eco-glasses such as titania at high temperatures without generating adverse surface chemistry effects in the molded element.

FIG. 14

EP 1 394 123 A1

**Description**

The present invention relates generally to the compression molding of glass lenses and, more particularly, to methods and apparatus for molding environmentally friendly glass (eco-glass) lenses using metal ion implanted mold tools.

Various methods and apparatus for the compression molding of glass optical elements are known in the prior art. With these methods and apparatus, optical element preforms (sometimes referred to as gobs) are compression molded at high temperatures to form glass lens elements. The basic process and apparatus for molding glass elements is taught in a series of patents assigned to Eastman Kodak Company. Such patents are U.S. Patent No. 3,833,347 to Engle et al, U.S. Patent No. 4,139,677 to Blair et al, and U.S. Patent No. 4,168,961 to Blair. These patents disclose a variety of suitable materials for construction of mold tooling used to form the optical surfaces in the molded optical glass elements. Those suitable materials for the construction of the mold tools included glasslike or vitreous carbon, silicon carbide, silicon nitride, tungsten carbide, a mixture of silicon carbide and carbon, and glasses such as YAS-6. In the practice of the process described in such patents, a glass preform is inserted into a mold cavity with the mold tools residing in an open position. The mold tools reside within a chamber that is maintained in a non-oxidizing atmosphere during the molding process. The preform and the mold tools are then heat softened to bring the viscosity of the preform into the range from $10^{10}$ P to $10^6$ P. The mold tools are then moved to a closed position thereby pressing the preform to conform to the shape of the mold cavity. The mold and preform are then allowed to cool below the glass transition temperature of the glass. The pressure on the mold tools is then relieved and the temperature is lowered further so that the finished molded lens can be removed from the mold tools.

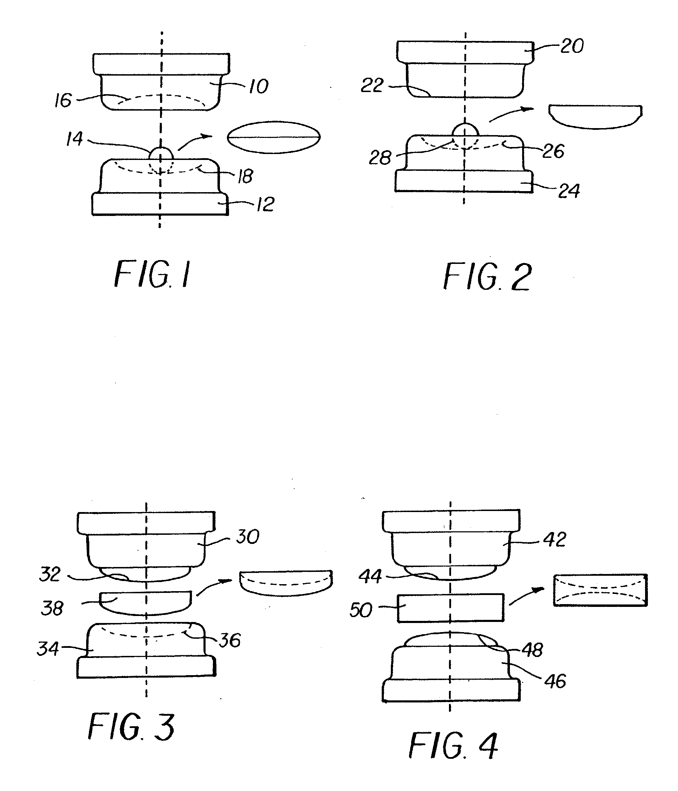

With regard to the compression molding of near-net-shape glass optical elements, it is well known that a glass preform with a precision polished surface must be pressed between the upper and lower mold halves (or tools) of a mold. If, for example, a double positive lens (convex-convex lens) is to be molded, a spherical or oblate spheroid glass preform of the proper volume is placed between the mold halves. The preform is heated until the glass has a viscosity in the range of $10^6$-$10^{10}$ Poise, and is compressed until the mold is closed. Then, preferably, mold halves and the preform are cooled to a temperature below the annealing point and the preform is removed from the mold cavity. Such an arrangement is depicted in Figure 1. The upper and lower mold halves 10, 12 compress a spherical glass preform 14 there between. The radius of the spherical glass preform 14 should be less than the radius of both of the concave mold surfaces 16, 18. As the glass preform 14 is compressed, the glass flows generally radially outwardly from the center of the mold cavity thereby expelling any gas from the mold cavity. This results in the production of a double convex lens free from distortion due to trapped gas. Such molded lenses typically have accurate and repeatable surface replication relative to the mold.

Depending on the final shape of the lens to be formed, specially shaped preforms are sometimes required to ensure that the glass flows from the center of the mold cavity to the peripheral edge of the mold cavity. Figures 2 through 4 depict prior art arrangements for molding plano-convex, concave-convex, and concave-concave lens elements, respectively. In Figure 2 the upper mold half 20 includes a plano mold surface 22 and the lower mold half 24 includes a concave mold surface 26. In such an arrangement, a spherical preform 28 is compression molded to produce a plano-convex optical element. In Figure 3 the upper mold half 30 includes a convex mold surface 32 and the lower mold half 34 includes a concave mold surface 36. In such an arrangement, it is preferred to use a plano-convex preform 38 to produce a concave-convex optical element. The radius of the convex surface of preform 38 should be less than the radius of concave mold surface 36. This ensures first contact between concave mold surface 36 and preform 38 substantially at the cylindrical axis or centerline of the mold halves 30,34 thereby causing the preform 38 to flow generally radially outwardly to prevent the trapping of gases. Similarly, the first contact between convex mold surface 32 and the plano surface of preform 38 is substantially at the cylindrical axis or centerline of the mold halves 30, 34 thereby also causing the preform 38 to flow generally radially outwardly to prevent the trapping of gases. In Figure 4 there is depicted another prior art arrangement wherein the upper mold half 42 includes a convex mold surface 44 and the lower mold half 46 includes a convex mold surface 48. In such an arrangement, it is preferred to use a plano-plano preform 50 to produce a double concave optical element. The plano-plano preform 50 ensures first contact between the mold surfaces 44, 48 and preform 50 substantially at the cylindrical axis or centerline of the mold halves 42, 46 thereby causing the preform to flow generally radially outwardly to prevent the trapping of gases. Examples of such practices are cited in U.S. Patent Nos. 5,662,951 and 4,797,144.

Although a wide variety of glasses have been used in precision glass molding, there remains a fundamental problem with the molding of oxide glasses. Some of the oxide glasses used for optical elements contain significant amounts of toxic heavy metals, such as lead. These glasses are fairly well behaved in the process and have long-been preferred for their high index of refraction and moldability among other factors. However, national and international regulations are being developed to limit or ban the use of products containing toxic substances such as lead, even in the form of lead oxide. For example, the Directive of the European Parliament and of the Council on Waste Electrical and Electronic Equipment (WEEE, Brussels 6/13/2002), does not allow the use of certain hazardous materials (including lead) in electronic devices that may be land filled at the end of their useful life. Based on this, there is an increasing interest in being able to handle environmentally safe glasses (herein often referred to as "eco-glasses"). There are glasses that use other metal compounds in place of the lead oxide, such as titanium oxide or titania, that are optically equivalent to the currently preferred glasses. However, when molding eco-glasses, such as titania based glasses, there is a chemical reaction between the titania glass and the mold surface which creates surface and subsurface defects rendering the molded lenses unacceptable for the intended applications.

Ion implantation technology is well known and has been used extensively in the microelectronics industry. Ion implantation was applied in the fabrication of microelectronics sometime in the mid-1960s when semiconductor companies realized that P-N junctions and buried layers were possible using ion implantation. Numerous surveys reported that ion beams were used in significant numbers in the industrial sector by the 1970s. Early applications of ion beams were directed to the removal of material (now called etching) and deposition using non-reactive beams.

In the early 1970s, it was found that ion implantation of metal surfaces could improve their wear, friction and corrosion properties. Ion implantation of specific tools is now preferred over other types of coating technologies because the ion implanted layer does not delaminate, does not require high processing temperatures to produce, and does not add more material on the surface (which would change the size of critical components). From the 1980s till today, their use has eventually progressed to reactive processes and property modification. Ion implantation is now used regularly to implant specific tools and equipment (e.g. score dies for aluminum can pop-tops and artificial knee and hip joints).

In recent years, numerous modifications of traditional ion implantation were developed such as knock-in implantation; which is a method for production of ultra-shallow profiles in semiconductors. In some cases implantation is performed through an oxide to thereby knock oxygen atoms into a substrate, typically silicon crystals. The oxygen atoms that recoil build a layer in the crystalline silicon that is occupied by oxygen within a few lattice distances. Knock-in effect is introduced usually in the 100Å range.

Ion implantation technology has not been used for the purpose of modifying the surface of mold tool surfaces to be used in the molding glass optical elements such as lenses. Further, the prior art fails to teach the use of a temporary solid thin film layer, like hard amorphous carbon, to partially attenuate the kinetic energy of the ion implanting species prior to impact and thereby control the depth of implantation.

It is therefore an object of the present invention to provide a method for molding optical elements from eco-glass preforms.

It is a feature of the present invention to provide a method for molding optical elements that obviates bubble formation at the mold surface/preform interface.

Yet another feature of the present invention is to provide a method for molding optical elements from eco-glasses such as titania at high temperatures without generating adverse surface chemistry effects in the molded element.

Still another feature of the present invention is to provide a method for fabricating molding tools which can be used to mold optical elements from eco-glasses such as titania at high temperatures without generating adverse surface chemistry effects in the molded element.

Briefly stated, the foregoing and numerous other features, objects and advantages of the present invention will become readily apparent upon a review of the detailed description, claims and drawings set forth herein. These features, objects and advantages are accomplished by implanting the molding surfaces of the mold tools with high-energy metal ion species. The method allows for control of the depth of ion implantation such that the ions are implanted to a depth of less than 200 Å. A mold tool is figured to have a predetermined molding surface. A layer of hard carbon is applied to the mold surface by physical vapor deposition or by other known methods of applying coating of uniform depth such as chemical vapor deposition. The layer of carbon should have a uniform thickness in the range of from 500 Å to 1500 Å. Metal ions, which react with oxygen to form a solid phase material, are implanted through the carbon layer into the molding surface, the carbon layer acting to control the depth of implantation. The carbon layer is then oxidized completely such as by burning to leave the predetermined molding surface having metal ions implanted therein. Following the implantation of these metal ion species, the implanted molding tool can be used to mold preforms of environmentally friendly glasses such as titania based glasses to form optical elements. Such optical elements include lenses such as, for example, plano-convex lenses, plano-concave lenses, convex-convex lenses, concave-convex lenses, concave-concave lenses, and lenses with aspheric, anamorphic, and diffractive features. In addition, such optical elements as may be molded with the method and tools of the present invention also include gratings and diffractive phase plates (Damman gratings).

In the molding process, the first and second mold halves or tools with the metal ion implanted molding surfaces and the glass preform are heated to at least the glass transition temperature of the glass preform. The glass preform is then pressed between the first and second mold halves to thereby form an optical glass element, optical element being a positive of the predetermined negative optical surface features of the mold halves. The optical element is subsequently cooled to below the glass transition temperature thereof and removed from the first and second mold halves.

Figure 1 is a side elevational view of a prior art molding apparatus for compression molding a convex-convex glass lens from a spherical or ball preform.

Figure 2 is a side elevational view of a prior art molding apparatus for compression molding a plano-convex glass lens from a spherical or ball preform.

Figure 3 is a side elevational view of a prior art molding apparatus for compression molding a concave-convex glass lens from a plano-positive preform.

Figure 4 is a side elevational view of a prior art molding apparatus for compression molding a concave-concave glass lens from a plano preform.

Figure 5 is a representation of a top plan view of an exemplary plano-plano molded lens.

Figure 6 is a side elevational view of the exemplary plano-plano molded lens of Figure 5.

Figures 7, 8 and 9 all depict top plan views of exemplary plano-plano molded lenses all molded from an eco-glass preform using the prior art method of molding and showing the types of surface defects generated thereby.

Figure 10 is a phase diagram for a $SiO_2$ — $TiO_2$ system.

Figure 11 is a cross-sectional schematic of a molding apparatus (in an open position) used to practice the method of the present invention.

Figure 12 is a cross-sectional schematic of the molding apparatus of Figure 11 in a closed or molding position.

Figure 13 is a partially sectioned, side elevational view of a molding tool of the present invention.

Figure 14 is an enlarged view of the region within circle A of Figure 13.

Figure 15 is a simplified Ellingham diagram describing the thermodynamic behavior of a metal with respect to the partial pressure of oxygen present at a given temperature.

Figure 16 is a basic schematic of an ion implantation system.

Figure 17 is a graph plotting implantation titanium ion implantation depth (Å) versus titanium concentration (ions/nm$^3$) showing the effect of implanting ions into a molding surface with and without an attenuating layer present. The attenuating layer in each case was an amorphous hard carbon.

Figure 18 is a graph of a typical ion concentration profile with respect to depth, made on any given plano mold.

Figures 19 is a partially sectioned, side elevational view of a molding tool of the present invention after the mold surface has been coated with an attenuating layer of carbon but prior to ion implantation.

Figure 20 is an enlarged view of the region within circle B of Figure 19.

Figure 21 is a partially sectioned, side elevational view the molding tool of Figure 19 after the mold has been ion implanted with titanium ions through the attenuating layer of carbon.

Figure 22 is an enlarged view of the region within circle C of Figure 21.

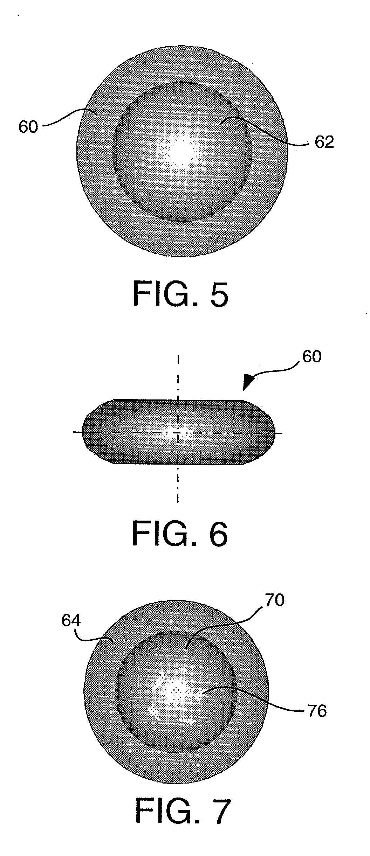

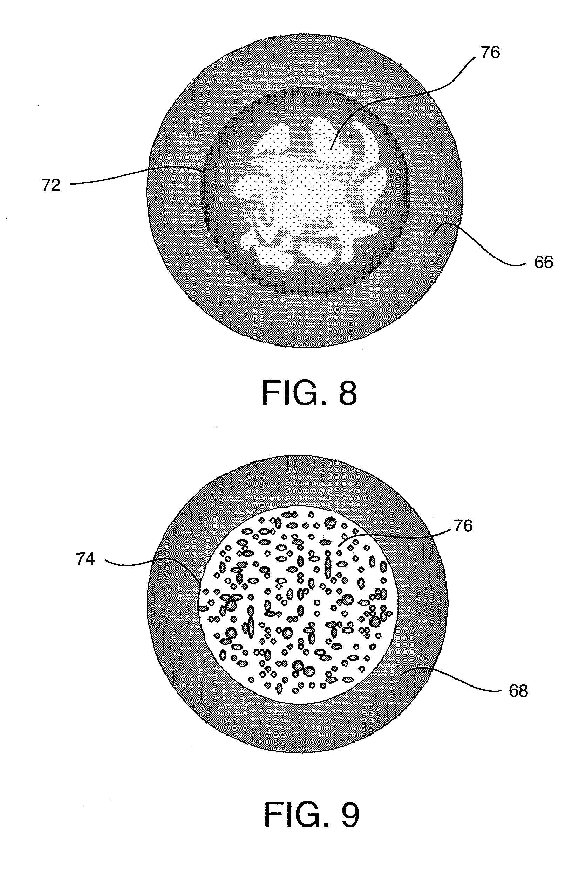

Looking at Figures 5 and 6 there is presented a representation of a top plan view and a side elevational view of an exemplary plano-plano molded lens 60 having an optical surface 62 that is free of defects. Figures 7, 8 and 9 all depict exemplary plano-plano molded lenses 64, 66, and 68 all molded from an eco-glass such as STIH-53 (Ohara Corporation, Rancho Santa Margarita, CA) using the prior art method of molding. Each lens 64, 66, 68 molded from an eco-glass has a respective optical surface 70, 72, 74 that has defects therein which appear as bubbles 76.

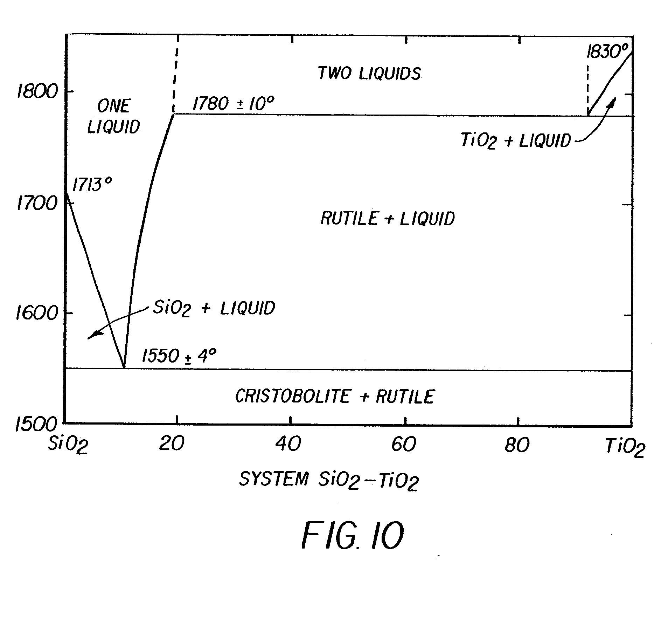

It is theorized that during the molding process, there are changes in the structure that release oxygen from the glass in the form of oxygen gas or oxygen ions which then react with other materials in the proximity of the glass preform-mold tool interface and create gaseous compounds (such as CO & $CO_2$) with enough pressure to form bubbles on the surface of the glass preform when Carbon is present at the interface. Phase equilibria studies suggest that $SiO_2$-$TiO_2$ glasses with titania greater than 7-mol% may be metastable. Titanium oxide rich zones precipitate in the form of phase-separated regions where the titanium is tetrahedrally and octahedrally coordinated with oxygen. This behavior is not surprising in the light of the phase diagram shown in Figure 10.

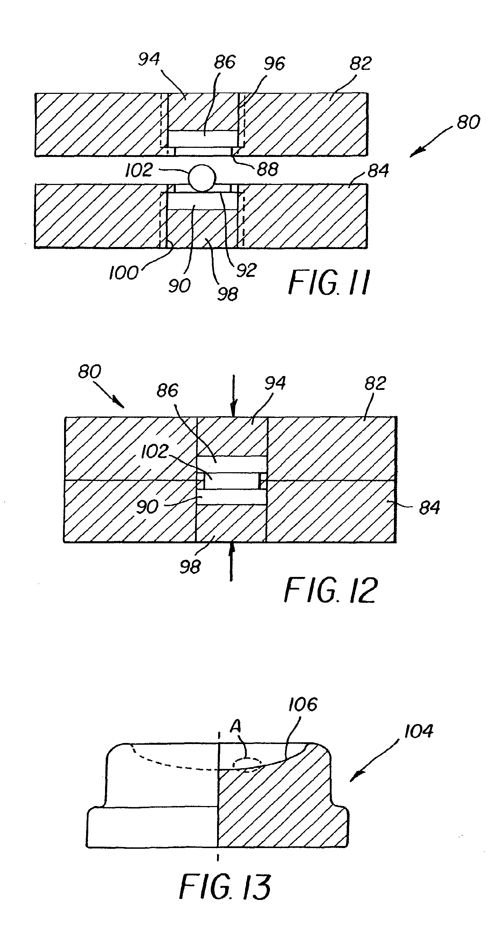

Turning next to Figure 11 there is shown a cross-sectional schematic of an apparatus 80 used to practice the method of the present invention. The apparatus 80 of the present invention includes an upper mold fixture 82 and the lower mold fixture 84. The upper mold fixture 82 has mounted therein an upper mold half or tool 86. Upper mold tool 86 is depicted as having a molding surface 88 that is plano. However, molding surface 88 may have other surface figures or shapes such as concave (see Figure 1) or convex (see Figure 4). Lower mold fixture 84 has mounted therein a lower mold half or tool 90. Lower mold tool 90 is depicted as having an exemplary molding surface 92 that is plano. However, molding surface 92, like molding surface 88 may also have other surface figures or shapes. Both mold surfaces 88, 92 are metal ion implanted. Mounting of upper mold half or tool 86 within upper mold fixture 82 is accomplished with support member 94 residing in bore 96. Similarly, mounting of lower mold half or tool 90 within lower mold fixture 84 is accomplished with support member 98 residing in bore 100. A mold or lens cavity is formed between upper mold half or tool 86 and lower mold half or tool 90 when upper mold fixture 82 and/or lower mold fixture 84 are moved to a closed or molding position (see Figure 12). This relative movement may be accomplished by moving upper mold fixture 82 toward lower mold fixture 84, or by moving lower mold fixture 84 toward upper mold fixture 82, or by moving both upper mold fixture 82 and lower mold fixture 84 toward each other. Surrounding upper and lower mold fixtures 82, 84 is a heating apparatus, preferably an induction-heating coil (not shown). In operation, a preform 102, such as STIH53 titania glass (Ohara Corporation) is placed on mold surface 92, and through actuation of induction heating coil, the temperature of the upper and lower mold fixtures 82, 84, mold tools 86, 90, and preform 102 is raised to at least the glass transition temperature of the preform 102. Then the perform 102 is pressed between the upper and lower mold fixtures 82, 84 causing the preform 102 to deform and flow generally radially outwardly in the mold cavity. As the preform 102 flows radially outwardly, it substantially fills the mold cavity. Compression is performed to a positive stop at which point the upper and lower mold fixtures 82, 84, mold tools 86, 90, and preform 102 are allowed to cool to below the glass transition temperature of the preform glass material, and preferably to below the annealing point of such glass. In such manner, an eco-glass lens 60 (see Figure 5) free of surface defects is formed. The molded lens can then be removed from the molding apparatus. It should be understood that upper and lower mold fixtures 82, 84 are not necessarily directly heated by induction. Rather, upper and lower mold fixtures 82, 84 preferably reside in a mold body (not shown) fabricated from a conductive material such as graphite or molybdenum. The mold body is heated by the induction field and the upper and lower mold fixtures 82, 84 are heated indirectly by conduction and radiant heat transfer.

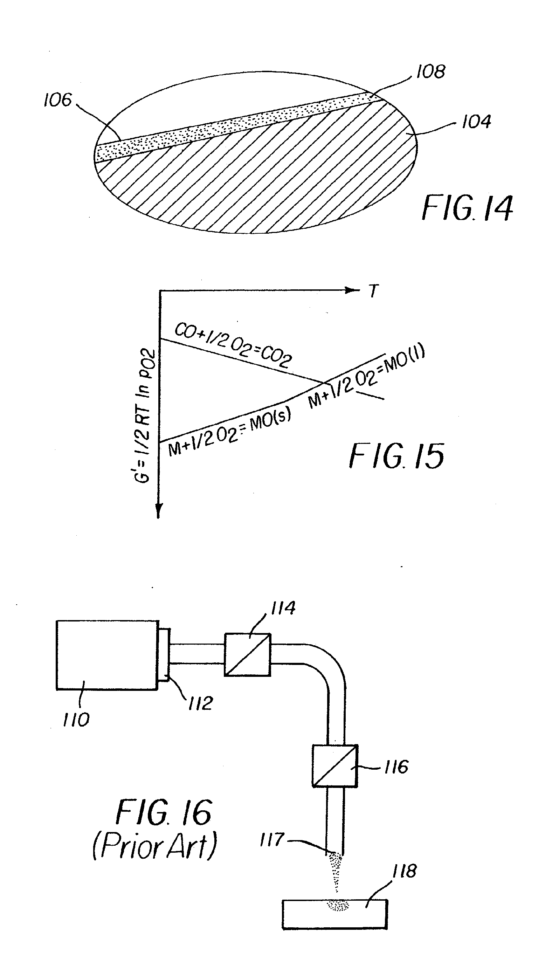

An exemplary mold tool 104 having a concave mold surface 106 is shown in Figure 13. The mold surface 106 (see Figure 14) has a metal ion implanted subsurface layer 108, with a metal such as titanium to a depth ranging from 0 to 200Å. Mold tool 104 is preferably formed from silicon carbide. However, mold tool 104 may be fabricated from other materials including glasslike or vitreous carbon, tungsten carbide, refractory metals and their oxides, carbides or nitrides (e.g. W, Mo, Rh, Ir), silicon nitride, glass, such as YAS-6 (MO-SCI Corporation, Rolla, Missouri), fused silica, and a mixture of silicon.

Lenses molded from eco-glasses using the method of the present invention are free from surface figure distortion that can be caused by the formation of bubbles at the interface between the mold surfaces and the glass preform during the molding operation. Experiments were conducted where STIH53 titania glasses (Ohara Corporation) were molded with titanium ion implanted mold tools 86, 90. After suitable heating time, the mold fixtures 82, 84 were brought together compressing each glass preform 102 into a final molded shape. The viscosity of the preform 102 was less than $10^{10}$P during the compression step. As the glass perform 102 was compressed between the mold tools 86, 90, the glass flowed generally radially outwardly and across the surface of the mold tools 86, 90 thereby substantially filling the lens cavity expelling nitrogen therefrom. In conducting this experiment, a force of 75 lbf. was applied to successfully mold optical elements (lenses). The viscosity, molding force, compression rate, lens mold geometry, location of the lens cavities relative to the initial location of the perform, and the sag of the lens mold will affect the propensity for void formation by stagnation, that is, the trapping of gas in the mold cavity. Typically, with mold glass lenses a release coating is applied to the mold surfaces, the preform, or both. The release coating is traditionally some variant of a hard carbon coating. However, there is an inherent propensity for carbon to react with any oxygen present and generate bubbles at the glass-mold interface, which could be trapped regardless of the inhibition created by the titanium ions implanted in the substrate. Therefore, alternate release coatings should be considered when necessary. It is preferred to place the release agent or coating on the mold surface rather than on the preform because the preform surface is remapped during the pressing operation. When the molding process is performed correctly, the curvature of the preform will always be greater than the curvature of the mold surface. In this way, the finished lens will always have a greater surface area than the surface area of the preform from which it was made. It is also possible to coat both the preform and the tool with a release coating other than carbon.

The heater described is an induction-type heater. Heating could also be performed using other types of heaters such as, for example, radiant heaters, resistance heaters, infrared heaters, halogen heaters, etc.

It is important to understand that the material choices for mold tools 86, 90, ion implantation species, and release coating (if any) are made in relation to the particular eco-glass from which preform 102 is made. The ion species is chosen according to the kinetics and thermodynamics of the mold-glass interface interactions. One key to successful molding is choosing an ion implantation process that prevents the formation of a gaseous substance trapped between the mold-glass interface in the molding operation. For example, an alternate embodiment to the present invention could use a tungsten carbide mold tool implanted with zirconium, hafnium (e. g. Group 4 elements from the Chemical Periodic Table) or other reducing element. Reducing substances or elements are those substances or elements that, under certain environmental conditions, will react with oxygen thereby causing adjacent substances of interest to reduce their oxidation state, in some cases to their neutral or ground state. In thermodynamics, the formation of a compound by means of a solid-gas reaction can be described by equation 1 and can be plotted as shown in Figure 15.

$$\Delta G^\circ = RT\ln(p_{O_2})^{\frac{1}{2}} \tag{1}$$

where $\Delta G^o$ is the Gibb's Free Energy of Formation for any substance, $R$ is the gas constant, $T$ is temperature in degrees Kelvin and $p_{O_2}$ is the partial pressure of oxygen at equilibrium. By plotting several curves, one can choose an element such as Ti or Zr, which have much larger negative free energies than Si or C, which will allow for the formation of the solid oxides of Ti and Zr rather than $CO_2$. However, there are limitations on the use of Equation 1 and it can only be used as a starting point for the selection of a candidate ion implantation species because equation 1 and the Ellingham diagram are only true when the reactions have reached equilibrium and the elements are pure. Once you introduce alloys and solutions, such as those existing in the glass preform 102 and the mold tools 82, 84, the partial pressures of oxygen needed for a given reaction will be lower than the ones obtained by Equation 1. It is also necessary that the ion species form a solid oxide, soluble in the glass of interest to prevent the formation of a gas. Finally, if the materials chosen have met the conditions for solid-solution equilibrium at the interface, they must not create disturbances in the other physical and chemical properties of the glass of interest for preform 102.

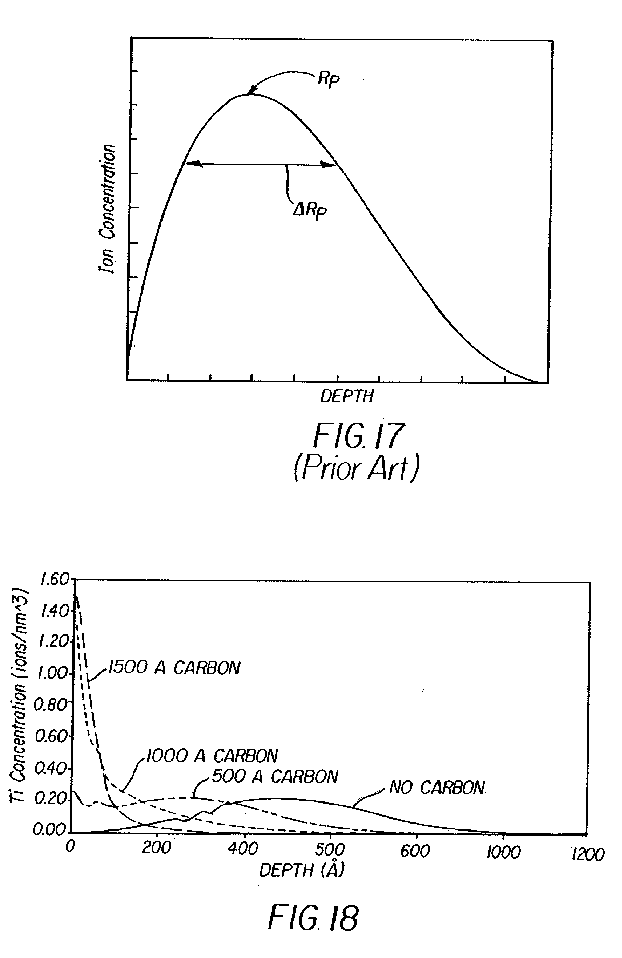

Turning to Figure 16 there is depicted a basic schematic of an ion implantation system. In general an ion implantation system comprises an ion source 110, which in a preferred embodiment of the present invention would be a titanium source. When a voltage is applied, an ion beam is generated and is accelerated and extracted through an extraction mechanism 112 and then filtered in an ion analyzing mechanism 114 dedicated to filtering the desired mass of the ion beam. The ion beam then passes through a second ion analyzing mechanism 116 that filters for the desired energy of the ion beam. The ion beam finally passes through a scanning station 117 that directs the beam to the substrate 118, which in the case of the present invention is a mold tool surface for molding of glass optical elements. An exemplary ion implantation system that is suitable for use in the practice of the method of the present invention is the Eaton Nova 10-160 High Current Ion Implanter as sold by Eaton Semiconductor of Beverly, MA. The resulting ion implantation profile for a given substrate is typically presented in atoms or ions/cm$^3$ versus depth in the substrate as seen in Figure 17. These profiles can be estimated by using Equations 2 and 3 to calculate the mean projected range, $R_p$, and the straggle, $\Delta R_p$. The mean projected range is a measure of the average penetration depth of the ions, and is defined as:

$$R_p = \frac{\left(\sum_i x_i\right)}{N} \qquad \text{Eq. 2}$$

where $N$ is the number of ions, and $x_i$ is the perpendicular distance from the surface to the end of each ion track. Straggling is a measure of the width of the distribution and is given by:

$$\Delta R_p = \sqrt{\frac{\left(\sum_i x_i - R_p\right)}{N}} \qquad \text{Eq. 3}$$

The objective of modeling efforts with regard to ion implantation is to predict the distribution of implanted ions for a given combination of ion species, ion energy and target species. To accomplish this task requires a detailed knowledge of how the ions lose energy during collisions.

Several plano silicon carbide tools were implanted with titanium ions and energy ranging from 85 keV to 175 keV. In the experiments performed, the samples were implanted with a constant titanium dose of 1x 10$^{15}$ ions/cm$^3$ (10 ions/nm$^2$). Initially there were concerns about the migration of the titanium ions from its original depth when subjected to high temperature molding conditions needed. Annealing experiments were performed and the migration of the peak ion concentration $R_p$ with respect to depth was found to be insignificant. Actual measurements of the ion concentration with respect to depth were made on plano mold tools to verify the ion implantation profiles and to assess the effect of using the carbon coating. Secondary Ion Mass Spectrometry, SIMS, was used to obtain the ion implantation profile shown in Figure 18. The plot in Figure 18 is shown with concentration in ions/nm$^3$ instead of the traditional atoms/cm$^3$ because it is easier to understand the physical implication of the concentration of 1 titanium ion/nm$^3$ more than 1x10$^{21}$ titanium ions/cm$^3$. Further, it can be seen that the experiments performed show how the peak concentration $R_p$ (in reference to equation 2) becomes shallower with an increase in the thickness of the carbon coating.

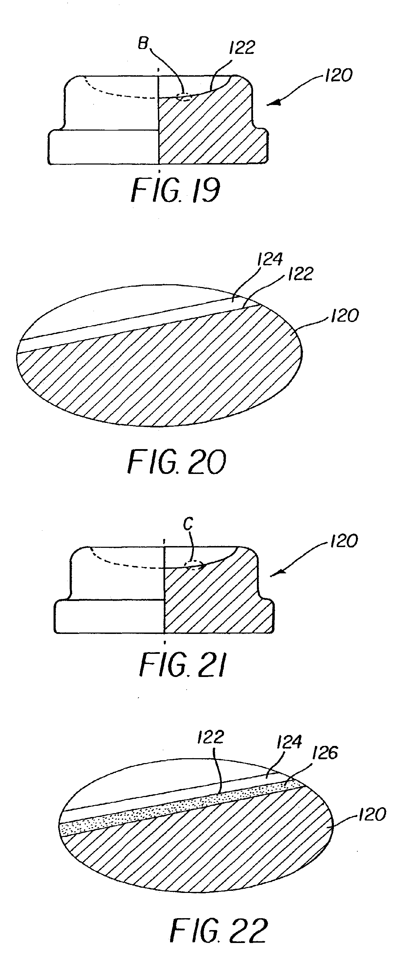

Figures 19 and 20 show an exemplary mold tool 120 after the mold surface 122 has coated with an attenuating layer 124 of carbon. Figures 21 and 22 show the exemplary mold tool 120 after the mold surface 122 has been ion implanted with titanium ions through the attenuating layer 124 of carbon. The implanted region 126 extends to a depth of 1500 Å, depending on the thickness of the carbon coating 124. Following ion implantation, the carbon coating 124 is burned off the mold tool 120 yield the structure previously described with reference to Figures 13 and 14. Carbon readily oxidizes or burns forming carbon dioxide when subjected to air at temperatures greater than 300 °C. The remaining mold tool 120 is left with a high titanium ion concentration near the mold surface 122 without any changes in the surface geometry required for molding glass lenses.

From the foregoing it will be seen that this invention is one well adapted to attain all of the ends and objects herein above set forth together with other advantages which are apparent and which are inherent to the process.

**Claims**

1. A method for fabricating a molding tool for mold glass optical elements therewith comprising the steps of:

   (a) figuring the molding tool to have a predetermined mold surface;
   (b) applying an attenuating coating to the predetermined mold surface;
   (c) implanting metal ions through the attenuating coating and into the predetermined mold surface; and
   (d) removing the attenuating coating leaving the predetermined mold surface with metal ions implanted therein.

2. A method as recited in claim 1 wherein:

   the attenuating coating is a coating of hard carbon.

3. A method as recited in claim 2 wherein:

   the coating of hard carbon has a thickness in the range of from 500 to 1500 Å.

4. A method as recited in claim 1 wherein:

   the metal ions are implanted in the predetermined mold surface to a depth in the range of from 0 to 200 Å.

5. A method as recited in claim 1 wherein:

   the implanted metal ions are titanium.

6. A method as recited in claim 1 wherein:

   the implanted metal ions are zirconium.

7. A method as recited in claim 1 wherein:

   the implanted metal ions will react with oxygen to form a solid phase material.

8. A method as recited in claim 1 further comprising the step of:

   molding oxide glass preforms with the molding tool to form optical elements.

9. A method as recited in claim 1 further comprising the step of:

   molding eco-glass preforms with the molding tool to form optical elements.

10. A method as recited in claim 1 further comprising the steps of:

    (a) assembling at least two of the molding tools into a molding apparatus to form at least one mold cavity therebetween;
    (b) inserting an oxide glass preform in the at least one mold cavity;
    (c) heating the at least two of the molding tools and the oxide glass preform to at least the glass transition temperature of the oxide glass preform; and
    (d) compression molding the oxide glass preform into an optical element with the at least two of the molding tools.

**11.** A method as recited in claim 10 further comprising the steps of:

(a) allowing the at least two of the molding tools and the oxide glass preform to cool to below the glass transition temperature of the oxide glass preform while the at least two of the molding tools are in a closed position;
(b) separating the at least two of the molding tools to an open position; and
(c) removing the optical element from the molding tools.

FIG. 1

FIG. 2

FIG. 3

FIG. 4

60

62

## FIG. 5

60

## FIG. 6

64

70

76

## FIG. 7

FIG. 8

FIG. 9

FIG. 10

FIG. 11

FIG. 12

FIG. 13

*FIG. 14*

*FIG. 15*

*FIG. 16*
*(Prior Art)*

FIG. 17
(Prior Art)

FIG. 18

FIG. 19

FIG. 20

FIG. 21

FIG. 22

**European Patent Office**

## EUROPEAN SEARCH REPORT

Application Number

EP 03 07 7597

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 018, no. 313 (C-1212), 15 June 1994 (1994-06-15) -& JP 06 065718 A (NIPPON TUNGSTEN CO LTD), 8 March 1994 (1994-03-08) * abstract * | 1-9 | C03B11/08 |
| A | PATENT ABSTRACTS OF JAPAN vol. 1998, no. 14, 31 December 1998 (1998-12-31) -& JP 10 259029 A (OLYMPUS OPTICAL CO LTD), 29 September 1998 (1998-09-29) * abstract * | 1-9 | |
| A | DATABASE WPI Section Ch, Week 199311 Derwent Publications Ltd., London, GB; Class A32, AN 1993-088281 XP002264768 -& JP 05 031767 A (OMRON CORP), 9 February 1993 (1993-02-09) * abstract * | 5,6 | |
| A | US 6 314 764 B1 (SAKAMOTO YASUAKI) 13 November 2001 (2001-11-13) * claim 1 * | 1-9 | TECHNICAL FIELDS SEARCHED (Int.Cl.7) C03B |
| A | US 5 855 641 A (TANIGUCHI YASUSHI) 5 January 1999 (1999-01-05) * column 13, line 4 - line 23; examples 8,10,14 * * column 16, line 46 - line 59; claim 1 * | 1-11 | |
| A | EP 1 069 082 A (EASTMAN KODAK CO) 17 January 2001 (2001-01-17) * column 3, paragraph 7; claim 1 * * column 5, line 0010 * | 10,11 | |

-/--

The present search report has been drawn up for all claims

| Place of search | Date of completion of the search | Examiner |
|---|---|---|
| MUNICH | 11 December 2003 | Deckwerth, M |

EPO FORM 1503 03.82 (P04C01)

EP 1 394 123 A1

**European Patent Office**

**EUROPEAN SEARCH REPORT**

Application Number

EP 03 07 7597

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 227 917 A (KUBO HIROYUKI ET AL) 13 July 1993 (1993-07-13) * column 5, line 59 - column 7, line 68 * ----- | 10,11 | |

TECHNICAL FIELDS SEARCHED (Int.Cl.7)

The present search report has been drawn up for all claims

| Place of search | Date of completion of the search | Examiner |
|---|---|---|
| MUNICH | 11 December 2003 | Deckwerth, M |

EPO FORM 1503 03.82 (P04C01)

18

## ANNEX TO THE EUROPEAN SEARCH REPORT
## ON EUROPEAN PATENT APPLICATION NO.

EP 03 07 7597

This annex lists the patent family members relating to the patent documents cited in the above-mentioned European search report.
The members are as contained in the European Patent Office EDP file on
The European Patent Office is in no way liable for these particulars which are merely given for the purpose of information.

11-12-2003

| Patent document cited in search report | | Publication date | Patent family member(s) | | Publication date |
|---|---|---|---|---|---|
| JP 06065718 | A | 08-03-1994 | JP | 3009761 B2 | 14-02-2000 |
| JP 10259029 | A | 29-09-1998 | NONE | | |
| JP 5031767 | A | 09-02-1993 | NONE | | |
| US 6314764 | B1 | 13-11-2001 | NONE | | |
| US 5855641 | A | 05-01-1999 | JP | 2815057 B2 | 27-10-1998 |
| | | | JP | 5339018 A | 21-12-1993 |
| | | | US | 5711780 A | 27-01-1998 |
| EP 1069082 | A | 17-01-2001 | US | 6305194 B1 | 23-10-2001 |
| | | | EP | 1069082 A2 | 17-01-2001 |
| | | | JP | 2001048554 A | 20-02-2001 |
| US 5227917 | A | 13-07-1993 | JP | 4031328 A | 03-02-1992 |

EPO FORM P0459

For more details about this annex : see Official Journal of the European Patent Office, No. 12/82